# EUROPEAN PATENT SPECIFICATION

(11) **EP 4 269 649 B1**
(45) Date of publication and mention of the grant of the patent: **28.01.2026**
(21) Application number: 21909362.2
(22) Date of filing: 21.12.2021
(51) Int. Cl.: C23C 14/35, C23C 14/02, H01J 37/34, H01J 37/32

(54) **MAGNETRON SPUTTERING DEVICE**
MAGNETRON-ZERSTÄUBUNGSVORRICHTUNG
DISPOSITIF DE PULVÉRISATION MAGNÉTRON

(30) Priority: 22.12.2020 CN 202011530202
(43) Date of publication of application: 01.11.2023
(73) Proprietor: Beijing NAURA Microelectronics Equipment Co., Ltd., Beijing 100176 (CN)
(72) Inventor: WU, Shubo, Beijing 100176 (CN); MA, Yinggong, Beijing 100176 (CN); SHI, Shuaitao, Beijing 100176 (CN); XU, Wenxue, Beijing 100176 (CN); GUO, Bingliang, Beijing 100176 (CN); ZHEN, Ziyang, Beijing 100176 (CN); ZHANG, Lu, Beijing 100176 (CN); CUI, Yaxin, Beijing 100176 (CN); ZHAI, Hongtao, Beijing 100176 (CN)
(74) Representative: Cohausz & Florack
(86) International application number: PCT/CN2021/139913
(87) International publication number: WO 2022/135366

(56) References cited:
- CN-A- 1 896 300
- CN-A- 106 816 397
- CN-A- 109 994 355
- CN-A- 109 994 356
- CN-A- 110 396 664
- CN-A- 112 760 609
- CN-B- 104 164 653
- CN-B- 110 396 664
- JP-A- H1 161 402
- US-A1- 2014 262 755
- US-A1- 2014 273 487

## Description

### TECHNICAL FIELD

The present disclosure generally relates to the semiconductor apparatus technology field and, more particularly, to a magnetron sputtering apparatus.

### BACKGROUND

In a deposition process of a semiconductor aluminum nitride (AlN) film, a pre-cleaning process needs to be performed on a wafer to remove contaminants and impurities before performing the deposition process of the AlN film on the wafer to enhance adhesion between the wafer and the AlN film and improve the deposition process result of the AlN film. Therefore, the chip performance is improved.

The pre-cleaning process is typically performed in a pre-cleaning chamber. The wafer needs to be heated through the pre-cleaning chamber. Argon (Ar) or nitrogen (N2) is introduced into the pre-cleaning chamber. The argon or nitrogen is excited to form a plasma in the pre-cleaning chamber. The plasma bombard the wafer to pre-clean the wafer. The deposition process of the AlN film is usually performed in a deposition chamber. The wafer needs to be heated through the deposition chamber. Argon and nitrogen are introduced into the deposition chamber. The argon and nitrogen are excited to form a plasma in the deposition chamber. An aluminum target is bombarded by argon ions to generate aluminum atoms. AlN is formed by combining the aluminum atoms with nitrogen atoms in the nitrogen and is deposited on the wafer to form the AlN film deposited on the wafer.

The existing pre-cleaning process and the deposition process of the AlN film are performed in two different chambers, which causes high manufacturing cost and maintenance cost. The wafer needs to be transferred between two different chambers. Thus, the entire process takes a long time, and the production capability of the apparatus is low.

D1 (CN110396664B) discloses that a capacitance adjustment device 16 and a bias radio frequency power supply 17 are configured to adjust a bias voltage on a surface of a wafer 11 during thin film sputtering; D2 (US2014/0262755A1) discloses a plasma etching apparatus for etching copper, which allows for using a DC power supply 514 and a pulse controller 516 to apply a bias voltage to a substrate 510 during an etching process; D3 (US2014/0273487A1) discloses a plasma etching apparatus including a DC bias source; and D4 (CN104164653B) discloses a magnetron sputtering apparatus including a bias unit.

### SUMMARY

The present disclosure aims to address at least one technical problem in the existing technology and provides a magnetron sputtering apparatus, which can lower the manufacturing cost and maintenance cost and avoid the transfer of the wafer between two different chambers to shorten the process time and improve the production capability. Therefore, according to the invention there is provided a magnetron sputtering apparatus according to claim 1. Further embodiments of the invention are defined in the dependent claims.

A magnetron sputtering apparatus is provided to realize the purpose of the present disclosure, which includes a process chamber, a bias power supply assembly, and an excitation power supply assembly. The process chamber is provided with a base assembly and a bias guide assembly. A target is arranged at a top of the process chamber.

The base assembly is arranged at a bottom of the process chamber and is configured to support a wafer carrier, drive the wafer carrier to move, and heat the wafer carrier.

The bias guide assembly is arranged on the base assembly and configured to support the wafer carrier, and the bias guide assembly electrically contacts the wafer carrier.

The bias power supply assembly is electrically connected to the bias guide assembly and configured to apply a bias voltage to the wafer carrier through the bias guide assembly.

The excitation power supply assembly is electrically connected to the target and configured to apply an excitation voltage to the target.

The bias power supply assembly includes a bias power supply, a matcher, and a radio frequency (RF) guide member. The RF guide member is sealed and arranged at a chamber wall of the process chamber. The bias power supply is configured to provide the bias voltage. The matcher is configured to realize impedance matching. An end of the RF guide member is electrically connected to the bias guide assembly, and another end of the RF guide member is electrically connected to the bias power supply through the matcher.

In some embodiments, the bias input assembly includes an insulation connector, a conductor, and a contact member. The conductor is inserted in the insulation connector, and two ends of the conductor are electrically connected to the bias power supply assembly and the contact member, respectively, and configured to guide the bias voltage provided by the bias power supply assembly to the contact member.

The insulation connector is arranged at the base assembly and configured to insulate the conductor from the base assembly.

The contact member electrically contacts the wafer carrier and is configured to support the wafer carrier and guide the bias voltage to the wafer carrier.

In some embodiments, the contact member is annular and includes at least one opening, and the opening is configured to allow a transfer member for transferring a wafer pass through.

In some embodiments, the insulation connector includes a first insulator and a second insulator. The conductor includes a first conductor and a second conductor. The first insulator is arranged horizontally at the base assembly, and the second insulator is arranged vertically at the first insulator.

The first conductor is inserted in the first insulator and extends from the first insulator to be electrically connected to the bias power supply assembly. The second conductor is inserted in the second insulator and extends from the second insulator to be electrically connected to the first conductor and the contact member.

In some embodiments, the first insulator includes a first insulation member and a second insulation member intersecting with each other, and the second insulator is vertically arranged at the second insulator.

The first conductor includes a first conduction member and a second conduction member that are electrically connected. The first conduction member is inserted in the first insulation member and extends from the first insulation member to be electrically connected to the bias power supply assembly. The second conduction member is inserted in the second insulation member and electrically connected to the second conductor.

In some embodiments, the first insulator includes a first insulation connector and a second insulation connector. The first insulation connector and the second insulation connector are detachably connected. The first insulation connector is provided with a first accommodation groove. The second insulation connection member is provided with a second accommodation groove corresponding to the first accommodation groove. The first accommodation groove and the second accommodation groove cooperate to form an accommodation space. The first conductor is arranged in the accommodation space.

In some embodiments, a plurality of second insulators are provided. The plurality of second insulators are arranged at the first insulator at intervals. A number of the second conductors is same as a number of the second insulators. The plurality of second conductors are inserted in a plurality of second insulators in a one-to-one correspondence and are electrically connected to different positions of the contact member.

In some embodiments, The RF guide member is configured to guide the bias voltage provided by the bias power supply to the bias guide assembly.

In some embodiments, the RF guide member includes an RF guide structure and an RF shield structure. The RF shield structure is sealed and arranged at the chamber wall of the process chamber and is internally arranged with the first insulator. The RF guide structure is inserted in the first insulator and sealed and connected to the RF shield structure. An end of the RF guide structure is arranged in the process chamber and is electrically connected to the bias guide assembly. Another end of the RF guide structure is arranged outside of the process chamber and electrically connected to the bias power supply. A second insulator is sleeved at the end of the RF guide structure located in the process chamber. The RF guide structure is configured to guide the bias voltage provided by the bias power supply to the bias guide assembly. The RF shield structure is configured to shield the bias voltage guided by the RF guide structure.

In some embodiments, the RF guide structure includes a first guide member and a second guide member. The first guide member is sealed and connected to the end of the RF shield structure outside the process chamber. An end of the first guide member is connected to the bias power supply. Another end of the first guide member extends into the first insulator. The second guide member is sealed and connected to the end of the RF shield structure inside the process chamber. An end of the second guide member is connected to the bias guide assembly. Another end of the second guide member extends into the first insulator and is connected to the first guide member. The second insulator is sleeved at the end of the second guide member connected to the bias guide assembly.

Embodiments of the present disclosure have the following beneficial effects.

With the magnetron sputtering apparatus of the present disclosure, in the semiconductor pre-cleaning process, the base assembly can support the wafer carrier and drive the wafer carrier to move to the pre-cleaning process position in the process chamber. The wafer carrier is heated to the pre-cleaning process temperature. With the bias guide assembly, a bias voltage can be applied to the wafer carrier to cause the plasma generated by the pre-cleaning industry gas introduced in the process chamber to bombard the wafer carried by the wafer carrier. Thus, the semiconductor pre-cleaning process can be performed on the wafer. In the semiconductor film deposition process, the base assembly can be configured to support the wafer carrier and drive the wafer carrier such as the wafer to move to the film deposition position in the process chamber. The base assembly can be configured to heat the wafer carrier to the film deposition process temperature. With the excitation power supply assembly, the excitation voltage can be applied to the target to cause the film deposition process gas introduced into the process chamber to form the plasma to bombard the target to generate atoms of the target, which can be combined with the process gas of the film deposition process gas to form a to-be-recorded. Thus, the semiconductor film deposition process can be performed on the wafer. Thus, with the magnetic sputtering apparatus of the present disclosure, the process chamber, the bias power supply assembly, the excitation power supply, the base assembly, the bias guide assembly, and the target can be integrated together. In the same process chamber, the semiconductor pre-cleaning process and the semiconductor film deposition process can be performed to reduce the manufacturing cost and the maintenance cost. The wafer can be prevented from being transferred between different process chambers to shorten the process time and improve the production capacity.

### BRIEF DESCRIPTION OF THE DRAWINGS

FIG. 1 illustrates a schematic structural diagram of a magnetron sputtering apparatus according to an embodiment of the present disclosure.
FIG. 2 illustrates a schematic perspective structural diagram showing a bias guide assembly of a magnetron sputtering apparatus according to an embodiment of the present disclosure.
FIG. 3 illustrates a schematic structural diagram showing a side view of a bias guide assembly of a magnetron sputtering apparatus according to an embodiment of the present disclosure.
FIG. 4 illustrates a schematic structural diagram showing a bias power supply assembly of a magnetron sputtering apparatus according to an embodiment of the present disclosure.

**Reference numerals:**

| | | | | | | | |
|---|---|---|---|---|---|---|---|
| 1 | Process chamber | 11 | Gas inlet | 12 | Exhaust opening | 2 | Bias guide assembly |
| 21 | Contact member | 22 | First insulator | 221 | First insulation member | | |
| 222 | Second insulation member | | | 223 | First insulation connector | | |
| 224 | Second insulation | | connector | 23 | Second insulator | | |
| 24 | Conductive part | 241 | First conductor | 242 | Second conductor | | |
| 2421 | Protrusion | 3 | Bias power supply assembly | | | 31 | Bias power supply |
| 32 | Radio frequency (RF) guide part | | | 321 | RF guide structure | | |
| 3211 | First guide member | | | 3212 | Second guide member | | |
| 322 | RF shield structure | | | 3221 | Second insulation part | | |
| 3222 | First insulation part | | | 33 | Matcher | | |
| 4 | Target | 5 | Excitation power supply assembly | | | | |
| 6 | Base assembly | 61 | Heating light | 62 | Power supply member | | |
| 63 | Base body | 7 | Wafer carrier | 81 | First reflector | | |
| 82 | Second reflector | 91 | Insulation ring | 92 | Adapter | | |
| 93 | First shield member | | | 94 | Second shield member | | |
| 95 | Shield ring | | | 96 | Temperature measuring member | | |

### DETAILED DESCRIPTION OF THE EMBODIMENTS

To cause those skilled in the art to better understand the technical solution of the present disclosure, a magnetron sputtering apparatus of embodiments of the present disclosure is described in detail in connection with the accompanying drawings.

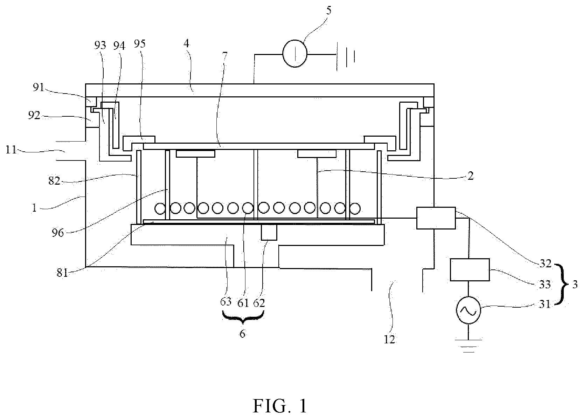

FIG. 1 illustrates a schematic structural diagram of a magnetron sputtering apparatus according to an embodiment of the present disclosure. The magnetron sputtering apparatus includes a process chamber 1, a bias power supply assembly 3, and an excitation power supply assembly 5. The process chamber 1 includes a base assembly 6 and a bias guide assembly 2. A target 4 is arranged at a top of the process chamber 1. The base assembly 6 is arranged at a bottom of the process chamber 1 and configured to support a wafer carrier 7, drive the wafer carrier 7 to move, and heat the wafer carrier 7. The bias guide assembly 2 is arranged at the base assembly 6 and configured to support the wafer carrier 7. The bias guide assembly 2 electrically contacts the wafer carrier 7. The bias power supply assembly 3 electrically contacts the bias guide assembly 2 and is configured to apply a bias voltage to the wafer carrier 7 through the bias guide assembly 2. The excitation power supply assembly 5 is electrically connected to the target 4 and configured to apply an excitation voltage to the target 4.

In the magnetron sputtering apparatus of embodiments of the present disclosure, in the semiconductor pre-cleaning process, the base assembly can be configured to support the wafer carrier 7, drive the wafer carrier 7 to move to a pre-cleaning position in the process chamber, and heat the wafer carrier 7 to a pre-cleaning process temperature. The bias guide assembly 2 can be configured to apply a bias voltage on the wafer carrier 7 to cause a pre-cleaning process gas in the process chamber 1 to form a plasma to bombard the wafer carried by the wafer carrier 7. Thus, the semiconductor pre-cleaning process can be performed on the wafer. In the deposition process of the semiconductor film, the base assembly 6 can be configured to support the wafer carrier 7, drive the wafer carrier 7 to move to a film deposition process position in the process chamber 1, and heat the wafer carrier 7 to a film deposition process temperature. The excitation power supply assembly 5 can apply an excitation voltage on the target 4 to cause a film deposition process gas in the process chamber 1 to form a plasma to bombard the target 4. A to-be-deposited substance is formed by combining atoms of the target and the film deposition process gas. Thus, the deposition process of the semiconductor film can be performed on the wafer. In the magnetron sputtering apparatus of embodiments of the present disclosure, by integrating the process chamber 1, the bias power supply assembly3, the excitation power supply assembly 5, the base assembly 6, the bias guide assembly 2, and the target 4, the pre-cleaning process and the deposition process of the semiconductor film can be performed in the same process chamber 1, which lowers the manufacturing cost and the maintenance cost. The transfer of the wafer between different process chambers can be avoided. Thus, the process time can be shortened, and the throughput can be improved.

As shown in FIG. 1, a description is made by taking the magnetron sputtering apparatus of embodiments of the present disclosure to perform the deposition process of the AlN film as an example. Before the deposition process of the AlN film is performed, the semiconductor pre-cleaning process needs to be performed first. In the semiconductor pre-cleaning process, the pre-cleaning gas is introduced into the process chamber 1. A manipulator (not shown) can be configured to transfer the wafer carrier 7 with a wafer (e.g., a chip) into the process chamber 1 and place the wafer carrier 7 and the wafer on the bias guide assembly 2 and the base assembly 6. The base assembly 6 and the bias guide assembly 2 can support the wafer carrier 7 together. The bias guide assembly is arranged on the base assembly 6. The base assembly 6 can drive the bias guide assembly 2 and the wafer carrier 7 to move to move the wafer carrier 7 to the pre-cleaning process position. The base assembly 6 can be configured to heat the wafer carrier 7 to the pre-cleaning process temperature to cause the temperature of the wafer carried by the wafer carrier 7 to reach a temperature required by the pre-cleaning process. The bias voltage of the bias power supply assembly 3 can be applied to the wafer carrier 7 through the bias guide assembly 2 electrically connected to the bias power supply assembly 3 and electrically contacting the wafer carrier 7. Thus, the pre-cleaning process gas introduced into the process chamber can be excited to form the plasma. The wafer can be bombarded with the plasma formed by the pre-cleaning process gas to realize the semiconductor pre-cleaning process.

After the semiconductor pre-cleaning process, the AlN film deposition process can be performed. In the AlN film deposition process, argon and nitrogen can be introduced into the process chamber 1 as the deposition process gas. The target 4 can include an aluminum target. The wafer carrier 7 carrying the wafer can remain on the base assembly 6 and the bias guide assembly 2. The base assembly 6 can be configured to support the bias guide assembly 2 and the wafer carrier 7 and drive the wafer carrier 7 to move to the film deposition process position. The base assembly 6 can be configured to heat the wafer carrier continuously until the wafer carrier reaches the temperature required by the film deposition process. The excitation power supply assembly 5 can be configured to apply an excitation voltage on the aluminum target to cause the argon and nitrogen introduced into the process chamber 1 to form the plasma. The aluminum target at the top of the process chamber 1 can be bombarded by argon ions to form aluminum atoms. The aluminum atoms can fall down in the process chamber. During this process, the aluminum atoms can be combined with the argon atoms to form AlN to be deposited on the wafer to realize the AlN film deposition process.

In the magnetron sputtering apparatus of embodiments of the present disclosure, since the base assembly can heat the wafer carrier 7 continuously after heating the wafer carrier 7 the pre-cleaning process temperature to cause the temperature of the wafer carrier 7 to reach the film deposition process temperature, the heating power output by the base assembly can change gradually. Thus, the base assembly 6 may not need to often switch between low power and high power. Therefore, the service time of the base assembly 6 can be extended, and the manufacturing cost and the maintenance cost can be reduced.

In the semiconductor pre-cleaning process of the AlN film deposition process, the pre-cleaning process gas can include argon or nitrogen, and the wafer carrier 7 can include a tray.

In some embodiments, as shown in FIG. 1, a gas inlet 11 and a gas outlet 12 are arranged at the process chamber 1. The gas inlet 11 is arranged on a side of the process chamber 1 and configured to allow the gas to enter the process chamber 1. The gas outlet 12 is arranged at the bottom of the process chamber 1 and configured to allow the gas to be discharged from the process chamber 1. The pre-cleaning process gas and the film deposition process gas can enter the process chamber through the gas inlet 11. The pre-cleaning process gas the film deposition process gas entering the process chamber 1 can be discharged from the process chamber through the gas outlet 12.

In some embodiments, as shown in FIG. 1, the excitation power supply assembly includes a DC power supply. The DC power supply is configured to apply a DC voltage to the target.

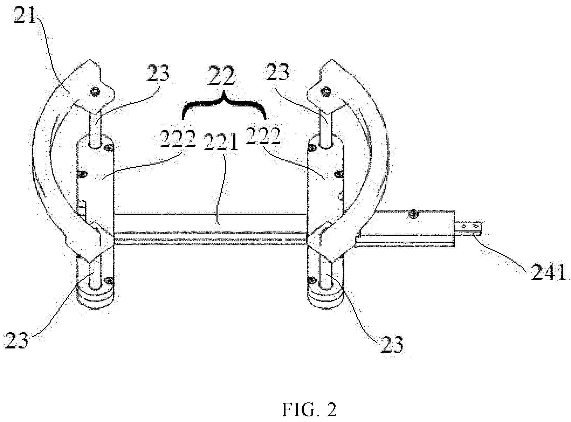

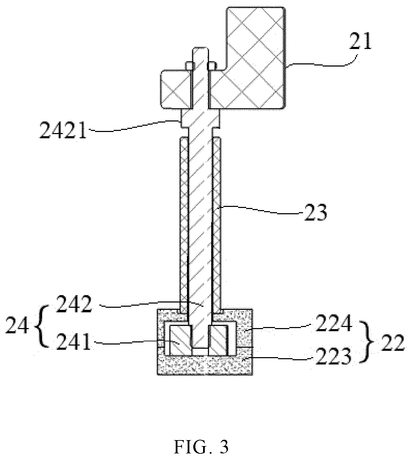

In some embodiments, as shown in FIG. 2 and FIG. 3, the bias guide assembly 2 includes an insulation connector, a conductive part 24, and a contact member 21. The conductive part 24 is inserted into the insulation connector. Two ends of the conductive part 24 are electrically connected to the bias power supply assembly 3 and the contact member 21, respectively, and configured to direct the bias voltage provided by the bias power supply assembly 3 to the contact member 21. The insulation connector is arranged at the base assembly 6 and configured to electrically insulate the conductive part 24 from the base assembly 6. The contact member 21 is in electrical contact with the wafer carrier 7 and configured to support the wafer carrier 7 and direct the bias voltage to the wafer carrier 7.

When the wafer carrier 7 is arranged on the bias guide assembly 2, the contact member 21 can be in contact with and electrically connected to the wafer carrier 7. The conductive part 24 is inserted into the insulation connector. The two ends of the conductive part 24 are electrically connected to the bias power supply assembly 3 and the contact member 21, respectively, and configured to direct the bias voltage provided by the bias power supply assembly 3 to the contact member 21. That is, the bias voltage provided by the bias power supply assembly 3 can be first applied to the conductive part 24, then transferred to the contact member 21 through the conductive part 24, and then transferred to the wafer carrier 7 through the contact member 21. The insulation connector is arranged on the base assembly 6 and configured to electrically insulate the conductive part 24 from the base assembly 6 to prevent the bias voltage conducted by the conductive part 24 from being conducted to the process chamber 1 through the base assembly. Thus, the bias voltage conducted by the conductive part 24 can be smoothly conducted to the contact member 21.

In some embodiments, as shown in FIG. 2, the contact member 21 is ring-shaped and includes at least one opening. The opening can be configured to allow a transfer part for transferring the wafer to pass through. That is, the contact member 21 includes a plurality of arc-shaped sub-contact members arranged along a circumference at intervals to form a ring-shaped contact member as a whole. An interval between two neighboring sub-contact members is the above opening. For example, FIG. 2 shows that the contact member 21includes two sub-contact members. The two sub-contact members are arranged symmetrically relative to an axis of the base assembly 6. Two intervals between the two sub-contact members can be the above openings, which are configured to allow the transfer member for transferring the wafer to pass through.

In the semiconductor film deposition process and the semiconductor pre-cleaning process, the wafer carrier 7 carrying with the wafer can be transferred into the process chamber 1 by the transfer member such as the manipulator. An opening is arranged at the contact member 21 and configured to allow the transfer member such as the manipulator to pass through. Thus, the transfer member can move to a position below the wafer carrier 7. Thus, the interference between the contact member 21 and the transfer member such as the manipulator can be avoided. Thus, the transfer member such as the manipulator cannot place the wafer and the wafer carrier 7 on the contact member 21 that is ring-shaped. Therefore, the transfer member such as the manipulator can smoothly place the wafer and the wafer carrier 7 on the contact member 21.

In some embodiments, as shown in FIG. 2 and FIG. 3, the above insulation connector includes a first insulator 22 and a second insulator 23. The conductive part 24 includes a first conductor 241 and a second conductor 242. The first insulator 22 is horizontally arranged on the base assembly 6. The second insulator 23 is vertically arranged on the first insulator 22. The first conductor 241 can be inserted into the first insulator 22 and extends from the first insulator 22 to be electrically connected to the bias power supply assembly 3. The second conductor 242 is inserted into the second insulator 23 and extends from the second insulator 23 to be electrically connected to the first conductor 241 and the contact member 21.

The first conductor 241 can be electrically connected to the bias power supply assembly 3, and the second conductor 242 is electrically connected to the first conductor 241 and the contact member 21. The bias voltage provided by the bias power supply assembly 3 can be first applied to the first conductor 241, then transferred to the second conductor 242 through the first conductor 241, and then transferred to the contact member 21 transmitted through the second conductive body 242 to the contact member 21.

The first insulator 22 and the second insulator 23 can insulate the first conductor 241 and the second conductor 242 from the base assembly 6 to prevent the bias voltage conducted by the first conductor 241 and the second conductor 242 from being conducted to the process chamber 1 through the base assembly 6. The first insulator 22 and the second insulator 23 can also be configured to support and fix the first conductor 241, the second conductor 241, and the contact member 21. Thus, these members can be stably fixed at the base assembly 6.

In some embodiments, as shown in FIG. 3, two ends of the second conductor 242 include external threads. One end of the two ends of the second conductor 242 includes a protrusion 2421. The first conductor 241 includes a hole with an internal thread. The contact member 21 includes a through-hole. By screwing the second conductor 242 through the external thread of one end of the second conductor 242 into the hole with the inner thread of the first conductor 241. Thus, the second conductor 242 is threadedly connected to the first conductor 241. Meanwhile, the second conductor 242 is electrically connected to the first conductor 241. By passing the other end of the second conductor 242 through the through-hole of the contact member 21, causing the protrusion 2421 to abut against the lower surface of the contact member 21, and then threadedly matching a nut with the external thread of the other end of the second conductor 242, the second conductor 242 can be threadedly connected to the contact member 21. Meanwhile, the second conductor 242 can be electrically connected to the contact member 21. The protrusion 2421 can be configured to support the contact member 21.

In some embodiments, as shown in FIG. 2, the first insulator 22 includes a first insulation member 221 and a second insulation member 222 that intersect with each other. The second insulator 23 is vertically arranged on the second insulation member 222. The first conductor 241 includes a first conductive member and a second conductive member (not shown) that intersect with each other and are electrically connected. The first conductive member is inserted in the first insulation member 221 along an extension direction of the first insulation member 221. The first conductive member extends out from the first insulation member 221 to be electrically connected to the bias power supply assembly 3. The second conduction member can be inserted in the second insulation member 222 along an extension direction of the second insulation member 222 and can be electrically connected to the second conductor 242. It can be easily understood that the shapes of the first insulation member 221 and the second insulation member 222 that intersect with each other match shapes of the first conductive member and the second conductive member that intersect with each other and are inserted in the first insulation member 221 and the second insulation member 222. As such, the support stability of the bias guide assembly 2 can be further improved.

In some embodiments, as shown in FIG. 2, the first insulation member 221 and the second insulation member 222 vertically intersect with each other. That is, the first insulation member 221 and the second insulation member 222 are perpendicular to each other. Correspondingly, the first conductive member and the second conductive member can vertically intersect with each other. However, an angle between the first insulation member 221 and the second insulation member 222 and an angle between the first conductive member and the second conductive member are not limited to this.

In some embodiments, as shown in FIG. 2, one first insulation member 221 is provided and two second insulation members 222 are provided. The two second insulation members 222 are parallel and spaced apart, and intersect with the first insulation member 221. Correspondingly, one first conductive member is provided, and two second conductive members are provided. The two second conductive members are inserted into the two second insulation members 222 along the extension directions of the second insulation members 222, respectively. The first conductive member is inserted in the first insulation member 221 along the extension direction of the first insulation member 221. Thus, the support stability of the bias guide assembly 2 can be further improved. However, the number of the second insulation members 222 are not limited and can be one, three, or more. The number of the second conductive members is equal to the number of the second insulation members 222. The second conductive members can be arranged in a one-to-one correspondence with the second insulation members 222.

In some embodiments, as shown in FIG. 3, the first insulator 22 includes a first insulation connector 223 and a second insulation connector 224. The first insulation connector 223 and the second insulation connector 224 can be detachably connected. The first insulation connector 223 includes a first accommodation groove. The second insulation connector 224 includes a second accommodation groove corresponding to the first accommodation groove. The first accommodation groove matches with the second accommodation groove to form an accommodation space. The first conductor 241 is arranged in the accommodation space.

As shown in FIG. 2 and FIG. 3, the first insulation connector 223 is divided into two parts, and the second insulation connector 224 is divided into two parts. A first part of the first insulation connector 223 is detachably connected to a first part of the second insulation connector 224 to form the first insulation member 221. A second part of the first insulation connector 223 is detachably connected to a second part of the second insulation connector 224 to form the second insulation member 222. An internal space of the first part of the first insulation connector 223 and an internal space of the first part of the second insulation connector 224 form a first part of the accommodation space. The second part of the first insulation connector 223 and an internal space of the second part of the second insulation connector 224 form a second part of the accommodation space. The first part and the second part of the accommodation space can communicate through through-holes arranged correspondingly at the first insulation connector 223 and the second insulation connector 224. When installing the first insulation body 22, the first conductor 241 is arranged in the first accommodation groove of the first insulation connector 223 (including the first part and the second part). Then, the second insulation connector 224 (including the first part and the second part) can enclose the first insulation connector 223. Thus, the second accommodation groove of the second insulation connector 224 and the first accommodation groove of the first insulation connector 223 can correspondingly cooperate to form the accommodation space. The first conductor 241 is arranged in the accommodation space.

In some embodiments, a manner of detachably connecting the first insulation connector 223 and the second insulation connector 224 can include that the first insulation connector 223 is snapped with the second insulation connector 224, then the threaded connector such as the screw is threadedly connected to the base assembly 6 by passing the threaded connector such as the screw through the through-holes of the second insulation connector 224 and the first insulation connector 223. Thus, the first insulation connector 223 and the second insulation connector 224 can be fixed at the base assembly 6.

After mounting the first insulator 22 on the base assembly 6, the second conductor 242 can be inserted into the second insulation member 222 and electrically connected to the first conductor 241. Then, the second insulator 23 is sleeved around the second conductor 242, and finally, the second conductor 242 can be electrically connected to the contact member 21, thereby completing the installation of the biasing input assembly 2.

In some embodiments shown in FIG. 2, the insulation connector includes a plurality of second insulators 23. The plurality of second insulators 23 are arranged at intervals at the first insulator 22. Correspondingly, the conduction part 24 includes a plurality of second conductor 242, and the plurality of second conductor 242 can be arranged in a one-to-one correspondence in the plurality of second insulator 23. Each of the plurality of second conductors 242 is electrically connected to the contact member 21. By arranging the plurality of second insulators 23, the contact member 21 can be supported at different positions, thereby improving the support stability of the bias guide assembly 2.

In some embodiments shown in FIG. 2, the insulation connector includes four second insulators 23. Two second insulators 23 are arranged on one of the second insulation members 222 at an interval. The other two second insulators 23 are arranged on the other second insulation members at an interval. In some embodiments, ends of the two second insulators 23 of the same second insulation member 222 are connected to positions close to two ends of the second insulation member 2, respectively. Thus, the second insulation member 222 can uniformly stressed. Correspondingly, the conductor 24 includes four second conductors 242, which are arranged in the one-to-one correspondence in the four second insulators 23. The two second conductors 242 can be electrically connected to one sub-contact member of the contact member 21. The other two second conductors 242 can be electrically connected to another sub-contact member. In some embodiments, the two second conductors 242 electrically connected to the same sub-contact member can be connected to the positions close to the two ends of the sub-contact member. Thus, the sub-contact member can be stably supported. However, the numbers of the insulation connectors and the second conductors 24 are not limited and can be two, three, or more.

In some embodiments as shown in FIG. 1, the bias power supply assembly 3 includes a bias power supply 31, a matcher 33, and a radio frequency (RF) guide part 32. The bias power supply 31 is configured to provide a bias voltage. The matcher 33 is configured to realize impedance matching. The RF guide part 32 is sealed and arranged on a chamber wall of the process chamber 1. One end of the RF guide part 32 is electrically connected to the bias guide assembly 2. The other end of the RF guide part 32 is electrically connected to the bias power supply 31 through the matcher 33 and configured to guide the bias voltage provided by the bias power supply 31 to the bias guide assembly 2.

As shown in FIG. 1, the bias power supply 31 and the matcher 33 are arranged outside the process chamber 1, the bias guide assembly 2 is arranged in the process chamber 1, and the RF guide part 32 is sealed and arranged on the chamber wall of the process chamber 1 to ensure the required sealing environment of the process chamber 1. One end of the RF guide part 32 is electrically connected to the bias guide assembly 2, and the other end is electrically connected to the bias power supply 31 through the matcher 33 to guide the bias voltage provided by the bias power supply 31 to the bias guide assembly 2 arranged in the process chamber 1. That is, the bias voltage provided by the bias power supply 31 can be first applied to the RF guide part 32 through the matcher 33, and then guided to the bias guide assembly 2 through the RF guide part 32.

The impedance matching can be performed by the matcher 33 to reduce the reflection power as much as possible. Thus, sufficient bias voltage can be guided into the bias guide assembly 2 to avoid wasting the bias voltage. Thereby, improving the utilization efficiency of the bias voltage to reduce process time and increase production capacity.

In some embodiments, as shown in FIG. 1, the bias power supply 31 includes an RF power supply. The RF power supply can be configured to apply the RF voltage to the bias guide assembly 2.

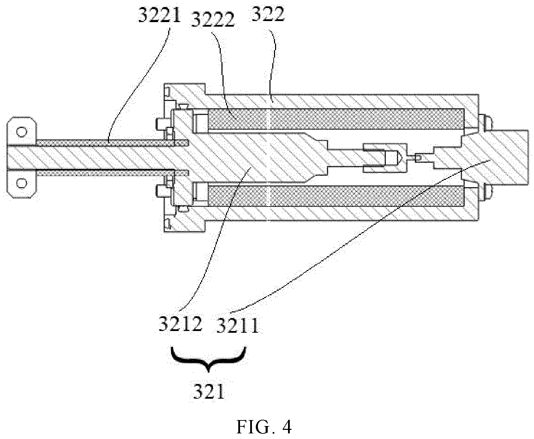

In some embodiments, as shown in FIG. 4, the RF guide part 32 includes an RF guide structure 321 and an RF shield structure 322. The RF shield structure 322 is sealably arranged on the chamber wall of the process chamber 1 and includes a first insulation component 3222. The RF guide structure 321 is inserted through the first insulation part 3222 inside the RF shield structure 322. The RF guide structure 321 is inserted in the first insulation part 3222 and sealed and connected to the RF shield structure 322. An end of the RF guide structure 321 is arranged in the process chamber 1 and electrically connected to the bias guide assembly 2. The other end of the RF guide structure 321 is arranged outside the process chamber 1 and electrically connected to the bias power supply 31. A second insulation part 3221 is sleeved at the end of the RF guide structure 321 in the process chamber 1. The RF guide structure 321 can be configured to guide the bias voltage provided by the bias power supply 31 to the bias guide assembly 2. The RF shield structure 322 can be configured to shield the bias voltage guided by the RF guide structure 321.

The RF shield structure 322 is sealably arranged on the chamber wall of the process chamber 1. The RF guide structure 321 is inserted in the first insulation part 3222 and sealed and connected to the RF shield structure 322 to ensure the required sealed environment of the process chamber 1. One end of the RF guide structure 321 is arranged in the process chamber 1 and electrically connected to the bias guide assembly 2. The other end of the RF guide structure 321 is arranged outside the process chamber 1 and electrically connected to the bias power supply 31. The bias voltage provided by the bias power supply 31 is first applied to the RF guide structure 321 through the matcher 33 and then guided to the bias guide assembly 2 through the RF guide structure 321 to guide the bias voltage provided by the bias power supply 31 that is located outside the process chamber 1 to the bias guide assembly 2 that is located inside the process chamber 1. The RF guide structure 321 is inserted in the first insulation part 3222 inside the RF shield structure 322. The end of the RF guide structure 321 located inside the process chamber 1 is sleeved with the second insulation part 3221 to electrically insulate the RF guide structure 321 from the chamber wall of the process chamber 1. Thus, the bias voltage guided by the RF guide structure 321 can be prevented from being conducted to the chamber wall of the process chamber 1 and unable to be conducted to the bias guide assembly 2, thereby allowing the RF guide structure 321 to smoothly guide the bias voltage to the bias guide assembly 2. The RF shield structure 322 can be configured to shield the bias voltage guided by the RF guide structure 321 to prevent the bias voltage guided by the RF guide structure 321 from expanding into the process chamber 1 to interfere other devices in the process chamber 1. Thus, the bias voltage guided by the RF guide structure 321 can be prevented from interfering with the semiconductor pre-cleaning process and the semiconductor film deposition process.

In some embodiments, as shown in FIG. 4, the RF guide structure 321 includes a first guide member 3211 and a second guide member 3212. The first guide member 3211 is sealed and connected to the end of the RF shield structure 322 located outside the process chamber 1. One end of the first guide member 3211 is connected to the bias power supply 31, and the other end of the first guide member 3211 extends into the first insulation part 3222. The second guide member 3212 is sealed and connected to the end of the RF shield structure 322 located inside the process chamber 1. One end of the second guide member 3212 is connected to the bias guide assembly 2. The other end of the second guide member 3212 extends into the first insulation part 3222 and is connected to the first guide member 3211. The second insulation part 3221 is sleeved at the end of the second guide member 3212 connected to the bias guide assembly 2.

The bias voltage provided by the bias power supply 31 can be first applied to the first guide member 3211 through the matcher 33, then guided to the second guide member 3212 through the first guide member 3211, and further guided to the bias guide assembly 2. The first guide member 3211 is sealed and connected to the end of the RF shield structure 322 located outside the process chamber 1, and the second guide member 3212 is sealed and connected to the end of the RF shield structure 322 located inside the process chamber 1 to cause the first guide member 3211 and the second guide member 3212 to be sealed with the RF shield structure 322, thereby ensuring a sealed environment required by the process chamber 1. The other end of the first guide member 3211 extends into the first insulation part 3222. The other end of the second guide member 3212 extends into the first insulation part 3222. The second insulation part 3221 is sleeved at the end of the second guide member 3212 that is connected to the bias guide assembly 2. Thus, the first guide member 3211 and the second guide member 3212 can be electrically insulated from the chamber wall of the process chamber 1 by the first insulation part 3222 and the second insulation part 3221. Therefore, the bias voltage guided by the first guide member 3211 and the second guide member 3212 can be prevented from being conducted to the chamber wall of the process chamber 1.

In some embodiments, the first guide member 3211 can include a threaded hole, and the second guide member 3212 can include an external thread corresponding to the threaded hole of the first guide member 3211. The first guide member 3211 can be electrically connected to the second guide member 3212 by threadedly matching the external thread of the second guide member 3212 with the threaded hole of the first guide member 3211.

When the RF guide part 32 is mounted, a portion of the second guide member 3212 sleeved with the second insulation part 3221 can be inserted into the process chamber 1. Thus, a portion of the second guide member 3212 can be arranged in the process chamber 1. Another portion of the second guide member 3212 can be located outside the process chamber1. Then, the second guide member 3212 can be connected to the first conductor 241. Then, the first insulation part 3222 can be sleeved around the portion of the second guide member 3212 located outside the process chamber 1. Then, the RF shield structure 322 can be sleeved around the first insulation part 3222. Finally, the first guide member 3211 can be inserted into the RF shield structure 322, connected to the second guide member 3212, and connected to the RF shield structure 322, thereby completing the installation of the RF guide part 32.

In some embodiments, the first guide member 3211 includes a through-hole. The RF shield structure 322 includes a threaded hole corresponding to the through-hole of the first guide member 3211. A threaded connector such as a screw can pass through the through-hole of the first guide member 3211 and threadedly cooperate with the threaded hole of the RF shield structure 322 to cause the first guide member 3211 to be connected to the RF shield structure 322.

In some embodiments, as shown in FIG. 1, the base assembly 6 includes a base body 63, a heating lamp 61, and a power supply member 62. The base body 63 is arranged at the bottom of the process chamber 1. The heating lamp 61 is arranged above the base body 63. The power supply member 62 is electrically connected to the heating lamp 61 to supply power to the heating lamp 61. The heating lamp 61 is arranged below the wafer carrier 7 that is arranged on the bias guide assembly 2. The heating lamp 61 is configured to emit infrared light to radiate the wafer carrier 7 to heat the wafer carrier 7.

In some embodiments, as shown in FIG. 1, the process chamber further includes a cooling member (not shown in the figure). The cooling member can be arranged in the base body 63.

By using the cooling component, the heat generated by the base assembly 6 can be prevented from radiating to the bottom of the process chamber 1. Thus, the interference of the device at the bottom of the process chamber 1 caused by the heat generated by the base assembly 6 can be avoided.

In some embodiments, as shown in FIG. 1, the process chamber further includes a first reflector 81 and a second reflector 82. The first reflector 81 is arranged at the base body 63 and below the heating lamp 61. The second reflector 82 is arranged at the base body 63 and surrounds the heating lamp 61. The first reflector 81 and the second reflector 82 can be configured to reflect the infrared light generated by the heating lamp 61 toward the wafer carrier 7. By reflecting the light generated by the heating lamp 61 towards the wafer carrier 7 using the first reflector 81 and the second reflector 82, the heating efficiency of the base assembly 6 on the wafer can be improved, thereby reducing the process time and increasing the production capacity.

In some embodiments, as shown in FIG. 1, the process chamber further includes a temperature measuring member 96. The temperature measuring member 96 is arranged at the base body 63 and in contact with the wafer carrier 7. The temperature measuring member 96 can be configured to measure the temperature of the wafer carrier 7 in the semiconductor pre-cleaning process and semiconductor film deposition process.

In some embodiments, as shown in FIG. 1, the process chamber further includes an insulation ring 91. The insulation ring 91 is sealed and arranged between the target 4 and the process chamber 1 and configured to seal the target and the process chamber 1 and electrically insulated the target 4 from the process chamber 1.

In some embodiments, as shown in FIG. 1, the process chamber further includes an adapter 92, a first shield member 93, a second shield member 94, and a shield ring 95. The adapter 92 can be arranged between the insulation ring 91 and the process chamber 1. The first shield member 93 is arranged at the adapter 92. The second shield member 94 is arranged at the first shield member 93. The first shield member 93 and the second shield member 94 can be configured to shield the inner wall of the process chamber 1 to prevent the inner wall of the process chamber 1 from being bombarded by the plasma in the semiconductor pre-cleaning process and semiconductor film deposition process, thereby improving the stability and service life of the process chamber 1. With the adapter 92, when maintenance or replacement needs to be performed on the first shield member 93 and the second shield member 94, only the adapter 92 may need to be removed from the process chamber 1 to disassemble the first shield member 93 and the second shield member 94. When using the first shield member 93 and second shield member 94 with different specifications and sizes, only a corresponding new adapter 92 may need to be used for the replacement to stably arrange the new first shield member 93 and second shield member 94 inside the process chamber 1, thereby facilitating maintenance or replacement of the first shield member 93 and the second shield member 94.

The shield ring 95 overlaps with the first shield member 93. In the semiconductor pre-cleaning process, the base assembly 6 can drive the bias guide assembly 2 to support the wafer carrier 7 below the shield ring 95. That is, in the semiconductor pre-cleaning process, the shield ring 95 overlaps with the first shield member 93. In the semiconductor film deposition process, the base assembly 6 can drive the bias guide assembly 2 to support the wafer carrier 7 to lift the shield ring 95 overlapping the first shield member 93. That is, in the semiconductor film deposition process, the shield ring 95 overlaps the wafer carrier 7 at an annular edge without carrying the wafer to prevent the annular edge of the wafer carrier 7 without carrying the wafer from being bombarded by the plasma in the semiconductor film deposition process to improve the service life of the wafer carrier 7.

In summary, in the magnetron sputtering apparatus of embodiments of the present disclosure, by integrating the process chamber, the bias power supply assembly, the excitation power supply assembly, the base assembly, the bias guide assembly, and the target together, the semiconductor pre-cleaning process and the semiconductor film deposition process can be performed in the same process chamber. Thus, the manufacturing cost and the maintenance cost can be lowered, and the wafer can be prevented from being transferred between different process chambers, thereby shortening the process time and improving the production capacity.
It should be understood that the above embodiments are merely illustrative examples adopted to explain the principles of the present disclosure. However, the present disclosure is not limited to this. Those skilled in the art can make various variations and improvements without departing from the scope of the invention, which is defined by the claims.

## Claims

1. A magnetron sputtering apparatus comprising a process chamber (1), a bias power supply assembly (3), and an excitation power supply assembly (5), wherein the process chamber (1) is arranged with a base assembly (6) and a bias guide assembly (2), and a target (4) is arranged at a top of the process chamber (1),
the base assembly (6) is arranged at a bottom of the process chamber (1) and is configured to support a wafer carrier (7), drive the wafer carrier (7) to move, and heat the wafer carrier (7);
the bias guide assembly (2) is arranged on the base assembly (6) and configured to support the wafer carrier (7), and the bias guide assembly (2) electrically contacts the wafer carrier (7);
the bias power supply (3) assembly is electrically connected to the bias guide assembly (2) and configured to apply a bias voltage to the wafer carrier (7) through the bias guide assembly (2); and
the excitation power supply (5) assembly is electrically connected to the target (4) and configured to apply an excitation voltage to the target (4); wherein
the bias power supply assembly (3) includes a bias power supply (31), a matcher (33), and a RF guide member (32), the RF guide member (32) is sealed and arranged at a chamber wall of the process chamber (1), the bias power supply (31) is configured to provide the bias voltage, the matcher (33) is configured to realize impedance matching, an end of the RF guide member (32) is electrically connected to the bias guide assembly (2), and another end of the RF guide member (32) is electrically connected to the bias power supply (31) through the matcher (33).

2. The magnetron sputtering apparatus according to claim 1, wherein the bias guide assembly (2) includes an insulation connector, a conductor (24), and a contact member (21), wherein the insulation connector is arranged at and insulated from the base assembly (6), the conductor (24) is inserted in the insulation connector, electrically connected to the bias power supply assembly (3) and the contact member (21), respectively, and configured to guide the bias voltage provided by the bias power supply assembly (3) to the contact member (21); and
the contact member (21) electrically contacts the wafer carrier (7) and is configured to support the wafer carrier (7) and guide the bias voltage to the wafer carrier (7).

3. The magnetron sputtering apparatus according to claim 2, wherein the contact member (21) is annular and includes at least one opening, and the opening is configured to allow a transfer member for transferring a wafer to pass through.

4. The magnetron sputtering apparatus according to claim 2, wherein the insulation connector includes a first insulator (22) and a second insulator (23), and the conductor (24) includes a first conductor (241) and a second conductor (242), wherein the first insulator (22) is arranged horizontally at and insulated from the base assembly (6), and the second insulator (23) is arranged vertically on the first insulator (22); and
the first conductor (241) is inserted in the first insulator (22) and extends from the first insulator (22) to be electrically connected to the bias power supply assembly (3), and the second conductor (242) is inserted in the second insulator (23) and extends from the second insulator (23) to be electrically connected to the first conductor (241) and the contact member (21), respectively.

5. The magnetron sputtering apparatus according to claim 4, wherein
the first conductor (241) includes a first conduction member and a second conduction member that intersect with each other, the first conduction member is electrically connected to the bias power supply assembly (3), and the second conductor (242) is arranged vertically on the second conduction member; and
the first insulator (22) has a shape matching a shape of the first conductor (241) and includes a first insulation member (221) and a second insulation member (222) that intersect with each other, the first conduction member is inserted in the first insulation member (221), the second conduction member is inserted in the second insulation member (222), and the second insulator (23) is arranged vertically on the second insulation member (222).

6. The magnetron sputtering apparatus according to claim 4, wherein the first insulator (22) includes a first insulation connector (223) and a second insulation connector (224), the first insulation connector (223) and the second insulation connector (224) are detachably connected, the first insulation connector (223) is provided with a first accommodation groove, and the second insulation connector (224) is provided with a second accommodation groove corresponding to the first accommodation groove, the first accommodation groove and the second accommodation groove cooperate to form an accommodation space, and the first conductor (241) is arranged in the accommodation space.

7. The magnetron sputtering apparatus according to claim 4, wherein the insulation connector includes a plurality of second insulators (23) and the conductor (24) includes a plurality of second conductors (242), wherein the plurality of second insulators (23) are arranged at the first insulator (22) at intervals, and the plurality of second conductors (242) are arranged in the plurality of second insulators (23) in a one-to-one correspondence and are electrically connected to the contact member (21) at intervals.

8. The magnetron sputtering apparatus according to claim 8, wherein the RF guide member (32) includes an RF guide structure (321) and an RF shield structure (322), the RF shield structure (322) is sealed and arranged at the chamber wall of the process chamber (1) and is internally arranged with the first insulator (3222), the RF guide structure (321) is inserted in the first insulator (3222) and sealed and connected to the RF shield structure (322), an end of the RF guide structure (321) is arranged in the process chamber (1) and is electrically connected to the bias guide assembly (2), another end of the RF guide structure (321) is arranged outside of the process chamber (1) and electrically connected to the bias power supply (31), a second insulator (3221) is sleeved at the end of the RF guide structure (321) located in the process chamber (1), the RF guide structure (321) is configured to guide the bias voltage provided by the bias power supply (31) to the bias guide assembly (2), and the RF shield structure (322) is configured to shield the bias voltage guided by the RF guide structure (321).

9. The magnetron sputtering apparatus according to claim 9, wherein the RF guide structure (321) includes a first guide member (3211) and a second guide member (3212), the first guide member (3211) is sealed and connected to the end of the RF shield structure (322) outside the process chamber (1), an end of the first guide member (3211) is connected to the bias power supply (31), another end of the first guide member (3211) extends into the first insulator (3222), the second guide member (3212) is sealed and connected to the end of the RF shield structure (322) inside the process chamber (1), an end of the second guide member (3212) is connected to the bias guide assembly (2), another end of the second guide member (3212) extends into the first insulator (3222) and is connected to the first guide member (3211), and the second insulator (3221) is sleeved at the end of the second guide member (3212) connected to the bias guide assembly (2).

## Patentansprüche

1. Magnetron-Sputtervorrichtung, eine Prozesskammer (1), eine Vorspannungsversorgungsbaugruppe (3) und eine Erregerstromversorgungsbaugruppe (5) aufweisend, wobei die Prozesskammer (1) mit einer Basisbaugruppe (6) und einer Vorspannungsführungsbaugruppe (2) angeordnet ist und ein Target (4) an einer Oberseite der Prozesskammer (1) angeordnet ist,
die Basisbaugruppe (6) an einem Boden der Prozesskammer (1) angeordnet ist und konfiguriert ist, um einen Waferträger (7) zu stützen, den Waferträger (7) anzutreiben, um ihn zu bewegen, und den Waferträger (7) zu erwärmen;
die Vorspannungsführungsbaugruppe (2) auf der Basisbaugruppe (6) angeordnet ist und konfiguriert ist, um den Waferträger (7) zu stützen, und die Vorspannungsführungsbaugruppe (2) elektrisch mit dem Waferträger (7) in Kontakt steht;
die Vorspannungsversorgungsbaugruppe (3) elektrisch mit der Vorspannungsführungsbaugruppe (2) verbunden ist und konfiguriert ist, um über die Vorspannungsführungsbaugruppe (2) eine Vorspannung an den Waferträger (7) anzulegen; und
die Erregerstromversorgungsbaugruppe (5) elektrisch mit dem Target (4) verbunden ist und konfiguriert ist, um eine Erregerspannung an das Target (4) anzulegen; wobei
die Vorspannungsversorgungsbaugruppe (3) eine Vorspannungsversorgung (31), einen Anpasser (33) und ein HF-Führungselement (32) aufweist, wobei das HF-Führungselement (32) abgedichtet ist und an einer Kammerwand der Prozesskammer (1) angeordnet ist, die Vorspannungsversorgung (31) konfiguriert ist, um die Vorspannung vorzusehen, der Anpasser (33) konfiguriert ist, um eine Impedanzanpassung zu verwirklichen, ein Ende des HF-Führungselements (32) elektrisch mit der Vorspannungsführungsbaugruppe (2) verbunden ist und ein anderes Ende des HF-Führungselements (32) über den Anpasser (33) elektrisch mit der Vorspannungsversorgung (31) verbunden ist.

2. Magnetron-Sputtervorrichtung nach Anspruch 1, wobei die Vorspannungsführungsbaugruppe (2) einen Isolierverbinder, einen Leiter (24) und ein Kontaktelement (21) aufweist, wobei der Isolierverbinder an der Basisbaugruppe (6) angeordnet ist und von dieser isoliert ist, der Leiter (24) in dem Isolierverbinder eingesetzt ist, elektrisch mit der Vorspannungsversorgungsbaugruppe (3) bzw. dem Kontaktelement (21) verbunden ist und konfiguriert ist, um die Vorspannung, die durch die Vorspannungsversorgungsbaugruppe (3) vorgesehen ist, zu dem Kontaktelement (21) zu führen; und
das Kontaktelement (21) elektrisch mit dem Waferträger (7) in Kontakt steht und konfiguriert ist, um den Waferträger (7) zu stützen und die Vorspannung zu dem Waferträger (7) zu führen.

3. Magnetron-Sputtervorrichtung nach Anspruch 2, wobei das Kontaktelement (21) ringförmig ist und mindestens eine Öffnung aufweist und die Öffnung konfiguriert ist, um einem Transferelement zum Transferieren eines Wafers zu erlauben, hindurchzutreten.

4. Magnetron-Sputtervorrichtung nach Anspruch 2, wobei der Isolierverbinder einen ersten Isolator (22) und einen zweiten Isolator (23) aufweist und der Leiter (24) einen ersten Leiter (241) und einen zweiten Leiter (242) aufweist, wobei der erste Isolator (22) horizontal an der Basisbaugruppe (6) angeordnet ist und von dieser isoliert ist und der zweite Isolator (23) vertikal auf dem ersten Isolator (22) angeordnet ist; und
der erste Leiter (241) in dem ersten Isolator (22) eingesetzt ist und sich von dem ersten Isolator (22) aus erstreckt, um elektrisch mit der Vorspannungsversorgungsbaugruppe (3) verbunden zu sein, und der zweite Leiter (242) in dem zweiten Isolator (23) eingesetzt ist und sich von dem zweiten Isolator (23) aus erstreckt, um elektrisch mit dem ersten Leiter (241) bzw. dem Kontaktelement (21) verbunden zu sein.

5. Magnetron-Sputtervorrichtung nach Anspruch 4, wobei
der erste Leiter (241) ein erstes Leitungselement und ein zweites Leitungselement aufweist, die sich schneiden, das erste Leitungselement elektrisch mit der Vorspannungsversorgungsbaugruppe (3) verbunden ist und der zweite Leiter (242) vertikal auf dem zweiten Leitungselement angeordnet ist; und
der erste Isolator (22) eine Gestalt, die einer Gestalt des ersten Leiters (241) entspricht, hat und ein erstes Isolierelement (221) und ein zweites Isolierelement (222) aufweist, die sich schneiden, wobei das erste Leitungselement in dem ersten Isolierelement (221) eingesetzt ist, das zweite Leitungselement in dem zweiten Isolierelement (222) eingesetzt ist und der zweite Isolator (23) vertikal auf dem zweiten Isolierelement (222) angeordnet ist.

6. Magnetron-Sputtervorrichtung nach Anspruch 4, wobei der erste Isolator (22) einen ersten Isolierverbinder (223) und einen zweiten Isolierverbinder (224) aufweist, der erste Isolierverbinder (223) und der zweite Isolierverbinder (224) lösbar miteinander verbunden sind, der erste Isolierverbinder (223) mit einer ersten Aufnahmenut versehen ist und der zweite Isolierverbinder (224) mit einer zweiten Aufnahmenut versehen ist, die der ersten Aufnahmenut entspricht, wobei die erste Aufnahmenut und die zweite Aufnahmenut zusammenwirken, um einen Aufnahmeraum zu bilden, und der erste Leiter (241) in dem Aufnahmeraum angeordnet ist.

7. Magnetron-Sputtervorrichtung nach Anspruch 4, wobei der Isolierverbinder mehrere zweite Isolatoren (23) aufweist und der Leiter (24) mehrere zweite Leiter (242) aufweist, wobei die mehreren zweiten Isolatoren (23) in Abständen an dem ersten Isolator (22) angeordnet sind und die mehreren zweiten Leiter (242) in den mehreren zweiten Isolatoren (23) in einer Eins-zu-eins-Entsprechung angeordnet sind und in Abständen elektrisch mit dem Kontaktelement (21) verbunden sind.

8. Magnetron-Sputtervorrichtung nach Anspruch 8, wobei das HF-Führungselement (32) eine HF-Führungsstruktur (321) und eine HF-Abschirmstruktur (322) aufweist, die HF-Abschirmstruktur (322) abgedichtet ist und an der Kammerwand der Prozesskammer (1) angeordnet ist und innen mit dem ersten Isolator (3222) angeordnet ist, die HF-Führungsstruktur (321) in dem ersten Isolator (3222) eingesetzt ist und abgedichtet ist und mit der HF-Abschirmstruktur (322) verbunden ist, ein Ende der HF-Führungsstruktur (321) in der Prozesskammer (1) angeordnet ist und elektrisch mit der Vorspannungsführungsbaugruppe (2) verbunden ist, ein anderes Ende der HF-Führungsstruktur (321) außerhalb der Prozesskammer (1) angeordnet ist und elektrisch mit der Vorspannungsversorgung (31) verbunden ist, ein zweiter Isolator (3221) an dem Ende der HF-Führungsstruktur (321), die sich in der Prozesskammer (1) befindet, aufgesteckt ist, die HF-Führungsstruktur (321) konfiguriert ist, um die Vorspannung, die von der Vorspannungsversorgung (31) vorgesehen ist, zu der Vorspannungsführungsbaugruppe (2) zu führen, und die HF-Abschirmstruktur (322) konfiguriert ist, um die Vorspannung, die von der HF-Führungsstruktur (321) geführt wird, abzuschirmen.

9. Magnetron-Sputtervorrichtung nach Anspruch 9, wobei die HF-Führungsstruktur (321) ein erstes Führungselement (3211) und ein zweites Führungselement (3212) aufweist, das erste Führungselement (3211) abgedichtet ist und mit dem Ende der HF-Abschirmstruktur (322) außerhalb der Prozesskammer (1) verbunden ist, ein Ende des ersten Führungselements (3211) mit der Vorspannungsversorgung (31) verbunden ist, ein anderes Ende des ersten Führungselements (3211) sich in den ersten Isolator (3222) erstreckt, das zweite Führungselement (3212) abgedichtet ist und mit dem Ende der HF-Abschirmstruktur (322) innerhalb der Prozesskammer (1) verbunden ist, ein Ende des zweiten Führungselements (3212) mit der Vorspannungsführungsbaugruppe (2) verbunden ist, ein anderes Ende des zweiten Führungselements (3212) sich in den ersten Isolator (3222) erstreckt und mit dem ersten Führungselement (3211) verbunden ist, und der zweite Isolator (3221) an dem Ende des zweiten Führungselements (3212), das mit der Vorspannungsführungsbaugruppe (2) verbunden ist, aufgesteckt ist.

## Revendications

1. Appareil de pulvérisation magnétron comportant une enceinte de traitement (1), un ensemble d'alimentation de polarisation (3) et un ensemble d'alimentation d'excitation (5), dans lequel l'enceinte de traitement (1) est pourvue d'un ensemble de base (6) et d'un ensemble de guidage de polarisation (2), et une cible (4) est disposée sur une partie supérieure de l'enceinte de traitement (1),
l'ensemble de base (6) est disposé sur une partie inférieure de l'enceinte de traitement (1) et est configuré pour supporter un porte-plaquettes (7), entraîner un déplacement du porte-plaquettes (7) et chauffer le porte-plaquettes (7),
l'ensemble de guidage de polarisation (2) est disposé sur l'ensemble de base (6) et configuré pour supporter le porte-plaquettes (7), et l'ensemble de guidage de polarisation (2) est électriquement en contact avec le porte-plaquettes (7),
l'ensemble d'alimentation de polarisation (3) est électriquement connecté à l'ensemble de guidage de polarisation (2) et configuré pour appliquer une tension de polarisation au porte-plaquettes (7) par l'intermédiaire de l'ensemble de guidage de polarisation (2), et
l'ensemble d'alimentation d'excitation (5) est électriquement connecté à la cible (4) et configuré pour appliquer une tension d'excitation à la cible (4),
dans lequel l'ensemble d'alimentation de polarisation (3) comprend une alimentation de polarisation (31), un adaptateur (33) et un élément guide RF (32), l'élément de guidage RF (32) est étanche et disposé sur une paroi d'enceinte de l'enceinte de traitement (1), l'alimentation de polarisation (31) est configurée pour délivrer la tension de polarisation, l'adaptateur (33) est configuré pour réaliser une adaptation d'impédance, une extrémité de l'élément de guidage RF (32) est électriquement connectée à l'ensemble de guidage de polarisation (2), et une autre extrémité de l'élément de guidage RF (32) est électriquement connectée à l'alimentation de polarisation (31) par l'intermédiaire de l'adaptateur (33).

2. Appareil de pulvérisation magnétron selon la revendication 1, dans lequel l'ensemble de guidage de polarisation (2) comprend un connecteur d'isolation, un conducteur (24) et un élément de contact (21), dans lequel le connecteur d'isolation est disposé sur l'ensemble de base (6) et isolé de celui-ci, le conducteur (24) est inséré dans le connecteur d'isolation, électriquement connecté à l'ensemble d'alimentation de polarisation (3) et à l'élément de contact (21), respectivement, et configuré pour guider la tension de polarisation délivrée par l'ensemble d'alimentation de polarisation (3) jusqu'à l'élément de contact (21), et
l'élément de contact (21) est électriquement en contact avec le porte-plaquettes (7) et est configuré pour supporter le porte-plaquettes (7) et guider la tension de polarisation jusqu'au porte-plaquettes (7).

3. Appareil de pulvérisation magnétron selon la revendication 2, dans lequel l'élément de contact (21) est annulaire et comprend au moins une ouverture, et l'ouverture est configurée pour permettre à un élément de transfert de transférer une plaquette afin de passer à travers celle-ci.

4. Appareil de pulvérisation magnétron selon la revendication 2, dans lequel le connecteur d'isolation comprend un premier isolateur (22) et un second isolateur (23), et le conducteur (24) comprend un premier conducteur (241) et un second conducteur (242), dans lequel le premier isolateur (22) est disposé horizontalement sur l'ensemble de base (6) et isolé de celui-ci, et le second isolateur (23) est disposé verticalement sur le premier isolateur (22), et
le premier conducteur (241) est inséré dans le premier isolateur (22) et s'étend à partir du premier isolateur (22) pour être électriquement connecté à l'ensemble d'alimentation de polarisation (3), et le second conducteur (242) est inséré dans le second isolateur (23) et s'étend à partir du second isolateur (23) pour être électriquement connecté au premier conducteur (241) et à l'élément de contact (21), respectivement.

5. Appareil de pulvérisation magnétron selon la revendication 4, dans lequel
le premier conducteur (241) comprend un premier élément de conduction et un second élément de conduction qui se croisent, le premier élément de conduction est électriquement connecté à l'ensemble d'alimentation de polarisation (3), et le second conducteur (242) est disposé verticalement sur le second élément de conduction, et
le premier isolateur (22) a une forme correspondant à une forme du premier conducteur (241) et comprend un premier élément d'isolation (221) et un second élément d'isolation (222) qui se croisent, le premier élément conducteur est inséré dans le premier élément d'isolation (221), le second élément conducteur est inséré dans le second élément d'isolation (222), et le second isolateur (23) est disposé verticalement sur le second élément d'isolation (222).

6. Appareil de pulvérisation magnétron selon la revendication 4, dans lequel le premier isolateur (22) comprend un premier connecteur d'isolation (223) et un second connecteur d'isolation (224), le premier connecteur d'isolation (223) et le second connecteur d'isolation (224) sont connectés de manière détachable, le premier connecteur d'isolation (223) est pourvu d'une première rainure de réception, et le second connecteur d'isolation (224) est pourvu d'une seconde rainure de réception correspondant à la première rainure de réception, la première rainure de réception et la seconde rainure de réception coopèrent pour former un espace de réception, et le premier conducteur (241) est disposé dans l'espace de réception.

7. Appareil de pulvérisation magnétron selon la revendication 4, dans lequel le connecteur d'isolation comprend une pluralité de seconds isolateurs (23) et le conducteur (24) comprend une pluralité de seconds conducteurs (242), dans lequel les isolateurs de la pluralité de seconds isolateurs (23) sont disposés sur le premier isolateur (22) à des intervalles, et les conducteurs de la pluralité de seconds conducteurs (242) sont disposés dans la pluralité de seconds isolateurs (23) en correspondance un à un et sont électriquement connectés à l'élément de contact (21) à des intervalles.

8. Appareil de pulvérisation magnétron selon la revendication 8, dans lequel l'élément de guidage RF (32) comprend une structure de guidage RF (321) et une structure de blindage RF (322), la structure de blindage RF (322) est étanche et disposée sur la paroi d'enceinte de l'enceinte de traitement (1) et est intérieurement pourvue du premier isolateur (3222), la structure de guidage RF (321) est insérée dans le premier isolateur (3222) et étanche et connectée à la structure de blindage RF (322), une extrémité de la structure de guidage RF (321) est disposée dans l'enceinte de traitement (1) et est électriquement connectée à l'ensemble de guidage de polarisation (2), une autre extrémité de la structure de guidage RF (321) est disposée à l'extérieur de l'enceinte de traitement (1) et électriquement connectée à l'alimentation de polarisation (31), un second isolateur (3221) est manchonné à l'extrémité de la structure de guidage RF (321) située dans l'enceinte de traitement (1), la structure de guidage RF (321) est configurée pour guider la tension de polarisation délivrée par l'alimentation de polarisation (31) jusqu'à l'ensemble de guidage de polarisation (2), et la structure de blindage RF (322) est configurée pour protéger la tension de polarisation guidée par la structure de guidage RF (321).

9. Appareil de pulvérisation magnétron selon la revendication 9, dans lequel la structure de guidage RF (321) comprend un premier élément de guidage (3211) et un second élément de guidage (3212), le premier élément de guidage (3211) est étanche et connecté à l'extrémité de la structure de blindage RF (322) à l'extérieur de l'enceinte de traitement (1), une extrémité du premier élément de guidage (3211) est connectée à l'alimentation de polarisation (31), une autre extrémité du premier élément de guidage (3211) s'étend dans le premier isolateur (3222), le second élément de guidage (3212) est étanche et connecté à l'extrémité de la structure de blindage RF (322) à l'intérieur de l'enceinte de traitement (1), une extrémité du second élément de guidage (3212) est connectée à l'ensemble de guidage de polarisation (2), une autre extrémité du second élément de guidage (3212) s'étend dans le premier isolateur (3222) et est connectée au premier élément de guidage (3211), et le second isolateur (3221) est manchonné sur l'extrémité du second élément de guidage (3212) connecté à l'ensemble de guidage de polarisation (2).
